Europäisches Patentamt

European Patent Office

Office européen des brevets

(19)

(11) **EP 0 965 170 B1**

(12) **EUROPÄISCHE PATENTSCHRIFT**

(45) Veröffentlichungstag und Bekanntmachung des Hinweises auf die Patenterteilung:
**20.02.2002 Patentblatt 2002/08**

(51) Int Cl.$^7$: **H03K 17/725**

(21) Anmeldenummer: **98952576.1**

(22) Anmeldetag: **18.09.1998**

(86) Internationale Anmeldenummer:
**PCT/DE98/02770**

(87) Internationale Veröffentlichungsnummer:
**WO 99/35744 (15.07.1999 Gazette 1999/28)**

(54) **SCHALTUNGSANORDNUNG ZUM VERBINDEN EINES ELEKTRISCHEN VERBRAUCHERS MIT EINER WECHSELSPANNUNGSQUELLE**

CIRCUIT SYSTEM FOR CONNECTING AN ELECTRICAL CONSUMER WITH AN ALTERNATING-VOLTAGE SOURCE

CIRCUIT POUR CONNECTER UN CONSOMMATEUR ELECTRIQUE AVEC UNE SOURCE DE TENSION ALTERNATIVE

(84) Benannte Vertragsstaaten:
**CH DE ES FR GB IT LI SE**

(30) Priorität: **05.01.1998 DE 19800147**

(43) Veröffentlichungstag der Anmeldung:
**22.12.1999 Patentblatt 1999/51**

(73) Patentinhaber: **ROBERT BOSCH GMBH**
**70442 Stuttgart (DE)**

(72) Erfinder:
• **KARL, Matthias**
  **D-76275 Ettlingen (DE)**
• **FREI, Martin**
  **D-71665 Vaihingen (DE)**

(56) Entgegenhaltungen:
**WO-A-96/07239          GB-A- 2 099 243**

**Beschreibung**

Die Erfindung betrifft eine Schaltungsanordnung zum Verbinden eines elektrischen Verbrauchers mit einer Wechselspannungsquelle, wobei der elektrische Verbraucher mit einem Schaltaktor in Reihe geschaltet ist und dem Schaltaktor eine elektronische Schaltung zugeordnet ist, deren Gleichspannungsversorgung durch den Schaltaktor erfolgt.

Stand der Technik

Schaltungsanordnungen der gattungsgemäßen Art sind bekannt. Diese werden beispielsweise in der Hausinstallation eingesetzt, wo elektrische Verbraucher über einen Bus variabel ansteuerbar sein sollen, und die Installation in einer sogenannten Zweileitertechnik erfolgt (Phase wird durchgeschaltet, kein Null-Leiter). Ein typisches Anwendungsbeispiel ist das Ein- beziehungsweise Ausschalten einer Beleuchtung. Als Schaltaktor werden bekanntermaßen Triacs oder Thyristoren eingesetzt, die innerhalb des Wechselspannungskreises in einen hochohmigen (Aus)-Zustand oder einen niederohmigen (Ein)-Zustand als mögliche Schaltzustände bringbar sind. Diese werden über eine elektronische Schaltung angesteuert, die ihre Gleichspannungsversorgung von dem Triac oder dem Thyristor bezieht. Ist der Triac oder der Thyristor im hochohmigen Zustand, wird über einen kapazitiven oder induktiven Vorwiderstand eine Schaltung zur Konstantspannungserzeugung als Gleichspannungsquelle für die elektronische Schaltung gespeist. Üblicherweise werden hierbei beispielsweise Zenerdioden oder Referenzdioden als Konstantspannungserzeuger eingesetzt.

Zur Ansteuerung der elektrischen Verbraucher wird der Triac beziehungsweise der Thyristor im niederohmigen Zustand in Phasenanschnittsteuerung betrieben, das heißt, je Halbwelle der Wechselspannung wird der Thyristor beziehungsweise Triac dann durchgesteuert, wenn sich am Konstantspannungserzeuger die dieser Ansteuerung entsprechende erforderliche Spannung aufgebaut hat.

Bei der bekannten Schaltungsanordnung ist nachteilig, daß der elektronischen Schaltung im hochohmigen Zustand des Schaltaktors nur ein relativ geringer Strom zur Verfügung steht, der durch den Innenwiderstand des elektrischen Verbrauchers begrenzt ist. Je höher der Innenwiderstand des elektrischen Verbrauchers ist, um so geringer ist der zur Verfügung stehende Strom. Ferner ist nachteilig, daß im niederohmigen Zustand des Schaltaktors dem elektrischen Verbraucher durch die Phasenanschnittsteuerung ein nicht unerheblicher Anteil der zur Verfügung stehenden Spannung und somit der Leistung vorenthalten wird. Hierdurch kann der elektrische Verbraucher seine Nennleistung, insbesondere bei relativ geringer Nennleistung, nicht erreichen.

Das Dokument WO-A-96/07239 offenbart eine Schaltungsanordnung zum Verbinden eines elektrischen Verbrauchers mit einer Wechselspannungsquelle nach dem Oberbegriff des Anspruchs 1.

Vorteile der Erfindung

Die erfindungsgemäße Schaltungsanordnung mit den im Anspruch 1 genannten Merkmalen bietet den Vorteil, daß die Bereitstellung der Gleichspannung für die dem Schaltaktor zugeordnete elektronische Schaltung, insbesondere im hochohmigen Zustand des Schaltaktors, verbessert: ist, und daß gleichzeitig der Schaltaktor und damit verbundene Geräte stabil in Zweileitertechnik betrieben werden können. Dadurch, daß der Schaltaktor einen Transformator umfaßt, der zwei umschaltbare Primärwicklungen aufweist, die in Reihe mit dem elektrischen Verbraucher schaltbar sind, wobei eine erste Primärwicklung eine niedrige Induktivität und eine zweite Primärwicklung eine hohe Induktivität aufweist, und die Sekundärwicklung einen Gleichrichter zur Bereitstellung der Gleichspannungsversorgung speist, ist vorteilhaft möglich, einerseits die Gleichspannung als Schutzkleinspannung zur Verfügung zu stellen, da über den Transformator eine galvanische Entkopplung von dem Primär- und somit Lastkreis erfolgt und andererseits durch Umschalten zwischen den zwei Primärwicklungen den hochohmigen beziehungsweise niederohmigen Zustand des Schaltaktors zu bestimmen. Im hochohmigen Zustand, der dem Ausschaltzustand des elektrischen Verbrauchers entspricht, kann ein relativ großer Innenwiderstand entsprechend der Induktivität der dem hochohmigen Zustand zugeordneten Primärwicklung erreicht werden, so daß auch ein Betrieb von elektrischen Verbrauchern mit sehr geringer Nennleistung möglich wird.

In bevorzugter Ausgestaltung der Erfindung ist vorgesehen, daß die den niederohmigen Zustand und somit den Einschaltzustand des elektrischen Verbrauchers bestimmende Primärwicklung mittels eines Schaltmittels kurzschließbar ist, wobei der Kurzschluß des Primärkreises in Abhängigkeit einer Nennleistung des zu schaltenden elektrischen Verbrauchers einstellbar ist. Hierdurch wird vorteilhaft erreicht, daß mittels der Schaltungsanordnung elektrische Verbraucher mit unterschiedlichen Nennleistungen, die in einem relativ großen Streubereich liegen können, schaltbar sind, ohne daß eine Überlastung des Transformators des Schaltaktors auftritt.

In weiterer bevorzugter Ausgestaltung der Erfindung ist vorgesehen, daß die Primärwicklungen mittels eines Schaltmittels umschaltbar sind, das von der dem Schaltaktor zugeordneten elektronischen Schaltung betätigbar ist. Hierdurch wird unabhängig vom Schaltzustand des Schaltaktors jederzeit eine Betätigung des Schaltmittels zum Umschalten zwischen den Primärwicklungen möglich, da die Betätigung über.die elektronische Schaltung erfolgt, deren Gleichspannungsversorgung unabhängig vom Schaltzustand des Schaltaktors erfolgt.

Weitere vorteilhafte Ausgestaltungen der Erfindung ergeben sich aus den übrigen, in den Unteransprüchen genannten Merkmalen.

Zeichnungen

Die Erfindung wird nachfolgend in Ausführungsbeispielen anhand der zugehörigen Zeichnungen näher erläutert. Es zeigen:

Figur 1 ein Prinzipschaltbild der erfindungsgemäßen Schaltungsanordnung;

Figur 2 ein Blockschaltbild der erfindungsgemäßen Schaltungsanordnung in einer ersten Ausführungsvariante;

Figur 3 eine Detaildarstellung der erfindungsgemäßen Schaltungsanordnung in einer zweiten Ausführungsvariante und

Figur 4 eine konkrete Schaltungsvariante der Schaltungsanordnung gemäß Figur 3.

Beschreibung der Ausführungsbeispiele

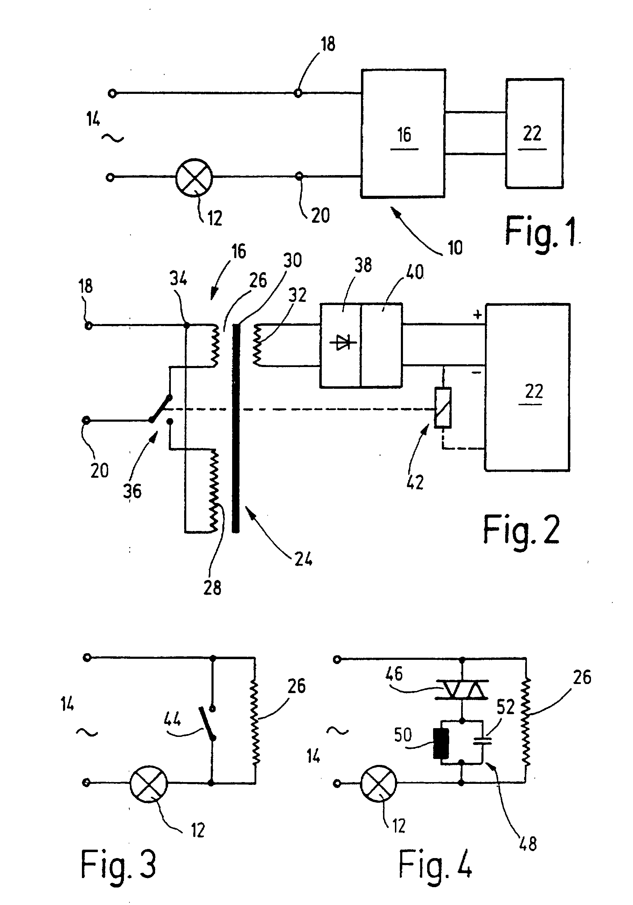

Figur 1 zeigt eine Schaltungsanordnung 10 zum Verbinden eines elektrischen Verbrauchers 12, beispielsweise einer Glühlampe, mit einer Wechselspannungsquelle 14. Die Wechselspannungsquelle 14 liefert beispielsweise eine Spannung von 230 Volt. Zum Einbeziehungsweise Ausschalten des elektrischen Verbrauchers 12 ist ein Schaltaktor 16 vorgesehen, der über Anschlußkontakte 18 beziehungsweise 20 in Reihe mit dem elektrischen Verbraucher 12 liegt. Dem Schaltaktor 16 ist eine elektronische Schaltung 22 zugeordnet, deren Gleichspannungsversorgung über den Schaltaktor 16 erfolgt. Nach einem konkreten Ausführungsbeispiel sind der Schaltaktor 16 und die elektronische Schaltung 22 als eine Baueinheit ausgeführt, die beispielsweise bei einer Hausinstallation in einer Schalter-Unterputzdose angeordnet sind und dem Ein- beziehungsweise Ausschalten des elektrischen Verbrauchers 12 dienen. Die elektronische Schaltung 22 umfaßt im einzelnen nicht dargestellte Schaltungsbestandteile und kann beispielsweise dem Einbinden des Schaltaktors 16 in eine leitungsgebundene beziehungsweise leitungslose Bus-Schaltung dienen. Mittels der Bus-Schaltung sind Schaltinformationen vorgebbar, die beispielsweise das Ein- beziehungsweise Ausschalten des elektrischen Verbrauchers 12 betreffen. Da die elektrische Schaltung 22 jederzeit zum Empfang der Informationen und zur Auslösung der Schaltfunktion des Schaltaktors 16 eine Energiequelle benötigt, wird diese über den Schaltaktor 16 in Form einer Gleichspannungsversorgung bereitgestellt.

Figur 2 zeigt eine konkrete Schaltungsvariante. Der Schaltaktor 16 umfaßt einen Transformator 24, der eine erste Primärwicklung 26 und eine zweite Primärwicklung 28 sowie eine über einen Magnetkreis 30 galvanisch von den Primärwicklungen 26, 28 entkoppelte Sekundärwicklung 32 besitzt. Die Primärwicklungen 26 und 28 sind einerseits mit einem Knotenpunkt 34 und andererseits mit Schaltkontakten eines Schaltmittels 36 verbunden. Das Schaltglied des Schaltmittels 36 ist mit der Anschlußklemme 20; der Knotenpunkt 34 mit der Anschlußklemme 18 (Figur 1) verbunden.

Die Sekundärwicklung 32 ist mit einem Gleichrichter 38 verbunden, dem ein Spannungsregler 40 nachgeschaltet ist. Die Ausgänge des Spannungsreglers 40 sind mit der elektronischen Schaltung 22 verbunden. Der elektronischen Schaltung 22 ist ein Relais 42 zugeordnet, dessen Spule über die elektronische Schaltung 22 mit einer Schaltspannung beaufschlagbar ist und dessen Schaltglied das Schaltmittel 36 betätigt. Nach weiteren Ausführungsbeispielen kann das Schaltmittel von einem Halbleiterbauelement, beispielsweise einem Thyristor, Triac oder Transistor, gebildet sein.

Die Primärwicklungen 26 und 28 sind so ausgelegt, daß die Primärwicklung 26 eine geringe Induktivität und die Primärwicklung 28 eine hohe Induktivität aufweist. Entsprechend der Induktivitäten der Primärwicklungen 26 und 28 besitzen diese einen proportional großen Blindwiderstand, der einen Innenwiderstand des Schaltaktors 16 bildet. Je nach Schaltstellung des Schaltmittels 36 wird der Innenwiderstand des Schaltaktors 16 durch die Primärwicklung 26 oder die Primärwicklung 28 bestimmt. Je nach Stellung des Schaltmittels 36 liegt der elektrische Verbraucher 12 (Figur 1) in Reihe mit der Primärwicklung 26 oder der Primärwicklung 28. Um den elektrischen Verbraucher 12 einzuschalten, wird die Primärwicklung 26 mit der niedrigen Induktivität und somit dem niedrigen Blindwiderstand (Innenwiderstand des Schaltaktors 16) in Reihe mit dem elektrischen Verbraucher 12 geschaltet. Ein Spannungsabfall über der Primärwicklung 26 liegt beispielsweise in einem Bereich von 0,2 bis 2 Volt. Zum Ausschalten des elektrischen Verbrauchers wird die Primärwicklung 28 mit der hohen Induktivität und somit dem hohen Blindwiderstand in Reihe mit dem elektrischen Verbraucher 20 geschaltet, so daß der hochohmige Zustand des Schaltaktors 16 erreicht wird. Ein Spannungsabfall über der Primärwicklung 28 liegt beispielsweise in einem Bereich von 50 bis 230 Volt. Hierdurch wird ein großer Innenwiderstand des Schaltaktors 16 erzielt, so daß die Schaltfunktion auch bei elektrischen Verbrauchern 12 mit relativ geringer Nennleistung möglich ist. Auch im hochohmigen Zustand des Schaltaktors 16 ist die Wechselspannungsquelle 14 über die Primärwicklung 28 mit dem elektrischen Verbraucher 12 verbunden, so daß ein Stromfluß aufrechterhalten bleibt. Hierdurch wird sichergestellt, daß auch im hochohmigen Zustand des Schaltaktors 16 eine Sekundärspannung an der Sekundärspule 32 in bekannter Weise abgegriffen werden kann, die zur Bereitstellung der Spannungsversorgung, nach Gleichrichtung über den Gleichrichter 38 und Spannungsregelung über den Spannungsregler 40 der elektronischen Schaltung 22 zur Verfügung steht. Durch den Transformator 24 erfolgt bekannterweise eine galvanische Trennung des Primärkreises vom Sekundärkreis, so daß im Sekundärkreis eine Sicherheitskleinspannung zur Verfügung gestellt werden kann, die keine - insbesondere im Hausinstallationsbereich - besonderen Isolierungsmaßnahmen bedarf.

Bei der in Figur 2 gezeigten Schaltungsvariante besteht das Problem, wenn die Schaltungsanordnung 10 für elektrische Verbraucher 12 mit unterschiedlicher Nennleistung eingesetzt werden soll, daß der Nennstrom $I_N$ entsprechend der Nennleistung des elektrischen Verbrauchers 12 stark variiert. Entsprechend der vereinfachten Berechnung

$$I = \frac{P}{U},$$

wobei U die Spannung der Wechselspannungsquelle von beispielsweise 230 V ist, ergibt sich eine Bandbreite des Nennstromes $I_N$ bei einem elektrischen Verbraucher 12 mit einer Nennleistung von 15 W bis zu einem elektrischen Verbraucher 12 mit einer Nennleistung von 400 W von zirka 60 mA bis 1,8 A. Um zu vermeiden, die Primärwicklung 26 auf den maximal möglichen Nennstrom $I_N$ auszulegen, ist gemäß der in Figur 3 gezeigten Schaltungsvariante vorgesehen, der Primärwicklung 26 ein Schaltmittel 44 parallel zu schalten. Dieses Schaltmittel 44 dient der Einstellung eines primären Kurzschlusses der Primärwicklung 26, wobei der primäre Kurzschluß lastabhängig, das heißt in Abhängigkeit des Nennstromes $I_N$ erfolgt. Dieser lastabhängige primäre Kurzschluß wird durch ein Verhältnis einer Einschaltzeit $T_1$ zu einer Ausschaltzeit $T_2$ des Schaltmittels 44 je Halbwelle des Nennstromes $I_N$ erreicht. Hierdurch erfolgt entsprechend des Zubeziehungsweise Auf-Zustandes des Schaltmittels 44 ein Zuschalten beziehungsweise Kurzschließen der Primärwicklung 26. Bei einem elektrischen Verbraucher 12 mit relativ geringer Nennleistung P, beispielsweise von 15 W, erfolgt kein primärer Kurzschluß, das heißt, die Einschaltzeit $T_1$ (geschlossener Zustand des Schaltmittels 44) beträgt 0 % der Stromhalbwelle des Nennstromes $I_N$. Entsprechend der tatsächlich gegebenen Nennleistung des elektrischen Verbrauchers 12 erfolgt nun eine Einstellung des Verhältnisses der Einschaltzeit $T_1$ zur Ausschaltzeit $T_2$. Bei einer angenommenen Leistung von 40 W beträgt das Verhältnis von $T_1$ zu $T_2$ beispielsweise 1, das heißt, die Einschaltzeit $T_1$ und die Ausschaltzeit $T_2$ je Halbwelle des Nennstromes $I_N$ ist gleich groß. Dies stellt einen späten primären Kurzschluß dar. Je höher die Nennleistung des elektrischen Verbrauchers 12 ist, um so größer wird das Verhältnis der Einschaltzeit $T_1$ zur Ausschaltzeit $T_2$ eingestellt. Bei einer angenommenen Nennleistung von 400 W beträgt das Verhältnis beispielsweise 18, bezogen auf die Halbwelle des Nennstromes $I_N$, so daß ein früher primärer Kurzschluß gegeben ist. Je höher die Nennleistung des elektrischen Verbrauchers 12, um so länger ist die Einschaltzeit $T_1$ des Schaltmittels 44 und entsprechend länger die Kurzschlußzeit der Primärwicklung 26 bezogen auf die Halbwelle des Nennstromes $I_N$.

Gemäß Figur 4 kann eine konkrete Umsetzung erfolgen, indem das Schaltmittel 44 von einem Triac 46 gebildet wird, der parallel zur Primärwicklung 26 geschaltet ist. Um während der Schaltvorgänge des Schaltmittels 44 (Triac 46) auftretende Spannungs- beziehungsweise Stromspitzen zu dämpfen, kann optional ein in Reihe zum Schaltmittel 44 liegender Schwingkreis 48 vorgesehen sein, der bekannterweise aus einer Parallelschaltung einer Induktivität 50 und einer Kapazität 52 besteht.

## Patentansprüche

1.  Schaltungsanordnung zum Verbinden eines elektrischen Verbrauchers (12) mit einer Wechselspannungsquelle (14) mit einem in Reihe mit dem elektrischen Verbraucher geschalteten Schaltaktor (16), wobei dem Schaltaktor eine elektronische Schaltung (22) zugeordnet ist, deren Gleichspannungsversorgung über den Schaltaktor erfolgt, wobei der Schaltaktor einen Transformator (24) mit zwei in Reihe mit dem elektrischen Verbraucher schaltbaren Primärwicklungen (26, 28) und einer Sekundärwicklung (32) aufweist, wobei die erste Primärwicklung (26) eine niedrige Induktivität und die zweite Primärwicklung (28) eine hohe Induktivität aufweist und die Sekundärwicklung (32) einen Gleichrichter (38) zur Bereitstellung der Gleichspannungsversorgung speist, **dadurch gekennzeichnet, daß** die Primärwicklungen (26, 28) mittels eines Schaltmittels (36) in Reihe mit dem elektrischen Verbraucher umschaltbar sind, das von der dem Schaltaktor (16) zugeordneten elektronischen Schaltung (22) betätigt ist.

2.  Schaltungsanordnung nach Anspruch 1, **dadurch gekennzeichnet, daß** das Schaltmittel (36) ein Relais (42) ist.

3.  Schaltungsanordnung nach Anspruch 1, **dadurch gekennzeichnet, daß** das Schaltmittel (36) ein Halbleiterbauelement ist.

4.  Schaltungsanordnung nach einem der vorhergehenden Ansprüche, **dadurch gekennzeichnet, daß** die erste Primärwicklung (26) mittels eines zweiten Schaltmittels (36) kurzschließbar ist.

5.  Schaltungsanordnung nach Anspruch 4, **dadurch gekennzeichnet, daß** eine Kur:zschlußdauer in Abhängigkeit einer Nennleistung des elektrischen Verbrauchers (12) einstellbar ist.

**6.** Schaltungsanordnung nach Anspruch 5, **dadurch gekennzeichnet, daß** die Kurzschlußdauer durch ein Verhältnis einer Einschaltzeit ($t_1$) zu einer Ausschaltzeit ($t_2$) des zweiten Schaltmittels (44) je Halbwelle der von der Wechselspannungsquelle (14) bereitgestellten Wechselspannung einstellbar ist.

**7.** Schaltungsanordnuhg nach einem der vorhergehenden Ansprüche, **dadurch gekennzeichnet, daß** das zweite Schaltmittel (44) ein Triac ist.

**8.** Schaltungsanordnung nach einem der vorhergehenden Ansprüche, **dadurch gekennzeichnet, daß** mit dem zweiten Schaltmittel (44) ein Schwingkreis (48) in Reihe geschaltet ist.

**Claims**

**1.** Circuit arrangement for connecting an electrical consumer (12) to an AC voltage source (14), having a switching actuator (16) connected in series to the electrical consumer, the switching actuator being assigned an electronic circuit (22) whose DC voltage supply is provided via the switching actuator, the switching actuator having a transformer (24) with two primary windings (26, 28) which can be connected in series with the electrical consumer, and a secondary winding (32), the first primary winding (26) having a low inductance and the second primary winding (28) having a high inductance, and the secondary winding (32) feeding an inverter (38) in order to provide the DC voltage supply, **characterized in that** the primary windings (26, 28) can be switched over with the aid of a switching means (36) which is in series with the electrical consumer and which is actuated by the electronic circuit (22) assigned to the switching actuator (16).

**2.** Circuit arrangement according to Claim 1, **characterized in that** the switching means (36) is a relay (42).

**3.** Circuit arrangement according to Claim 1, **characterized in that** the switching means (36) is a semiconductor component.

**4.** Circuit arrangement according to one of the preceding claims, **characterized in that** the first primary winding (26) can be short circuited by means of a second switching means (36).

**5.** Circuit arrangement according to Claim 4, **characterized in that** a short circuit duration can be set as a function of a nominal power of electrical consumer (12).

**6.** Circuit arrangement according to Claim 5, **characterized in that** the short circuit duration can be set by a ratio of an on time ($t_1$) to an off time ($t_2$) of the second switching means (44) every half wave of the AC voltage provided by the AC voltage source (14).

**7.** Circuit arrangement according to one of the preceding claims, **characterized in that** the second switching means (44) is a triac.

**8.** Circuit arrangement according to one of the preceding claims, **characterized in that** a resonant circuit (48) is connected in series with the second switching means (44).

**Revendications**

**1.** Circuit pour connecter un consommateur électrique (12) avec une source de tension alternative (14) comprenant,

- un commutateur (16) relié en série au consommateur (12) et auquel est associé un circuit électronique (12) alimenté en tension continue par l'intermédiaire du commutateur,
- le commutateur est un transformateur (24) comportant deux enroulements primaires (26, 28) qui peuvent être reliés en série au consommateur électrique, et un enroulement secondaire (32),
- le premier enroulement primaire (26) a une faible inductance et le second enroulement primaire (28) une inductance élevée,
- l'enroulement secondaire (32) alimente un redresseur (38) pour assurer l'alimentation à tension continue,

**caractérisé en ce que**
les enroulements primaires (26, 28) peuvent être reliés en série au consommateur électrique par l'intermédiaire d'un moyen de commutation actionné par le circuit électronique associé au commutateur (16).

**2.** Circuit selon la revendication 1,
**caractérisé en ce que**
le moyen de commutation (36) est un relais (42).

**3.** Circuit selon la revendication 1,
**caractérisé en ce que**
le moyen de commutation (3) est un élément semiconducteur.

**4.** Circuit selon l'une quelconque des revendications précédentes,

**caractérisé en ce que**
le premier enroulement primaire (26) peut être court-circuité au moyen d'un second moyen de commutation (36).

5. Circuit selon la revendication 4,
**caractérisé en ce que**
la durée du court-circuitage peut être réglée en fonction de la puissance nominale du consommateur électrique (12).

6. Circuit selon la revendication 5,
**caractérisé en ce que**
la durée du court-circuitage peut être réglée par le rapport d'un temps de fermeture ($t_1$) à un temps d'ouverture ($t_2$) du second moyen de commutation (44) pour chaque demi-onde de la tension alternative fournie par la source de tension alternative (14).

7. Circuit selon l'une quelconque des revendications précédentes,
**caractérisé en ce que**
le second moyen de commutation (44) est un triac.

8. Circuit selon l'une quelconque des revendications précédentes,
**caractérisé en ce qu'**
un circuit oscillant (48) est relié en série au second moyen de commutation (44).

Fig. 1

Fig. 2

Fig. 3

Fig. 4